(19) Europäisches Patentamt
European Patent Office
Office européen des brevets

(11) **EP 4 759 965 A2**

(12) **EUROPEAN PATENT APPLICATION**

(43) Date of publication:
**17.06.2026 Bulletin 2026/25**

(21) Application number: **25216803.4**

(22) Date of filing: **18.11.2025**

(51) International Patent Classification (IPC):
**C23C 18/16** (2006.01)    **H05K 9/00** (2006.01)
**C25D 7/04** (2006.01)

(52) Cooperative Patent Classification (CPC):
**C23C 18/1639; C23C 18/1644; C23C 18/1653;**
**H05K 9/009; C25D 7/04**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **21.11.2024 KR 20240167271**

(71) Applicant: **Hansol Chemical Co., Ltd**
**Seoul 06169 (KR)**

(72) Inventors:
• **PARK, Byung-Ju**
**54524 Iksan-si, Jeonbuk-do (KR)**

• **AHN, Damiro**
**54524 Iksan-si, Jeonbuk-do (KR)**
• **YANG, Seung-Woo**
**54524 Iksan-si, Jeonbuk-do (KR)**
• **YUN, Young-Ho**
**54524 Iksan-si, Jeonbuk-do (KR)**
• **KWON, Se-Man**
**54524 Iksan-si, Jeonbuk-do (KR)**

(74) Representative: **Ipsilon**
**Le Contemporain**
**50 Chemin de la Bruyère**
**69574 Dardilly Cedex (FR)**

(54) **ELECTROMAGNETIC SHIELDING NONWOVEN FABRIC CONTAINING CARBON FIBERS, COMPOSITE MATERIAL, AND METHOD FOR MANUFACTURING SAME**

(57) Proposed are a nonwoven fabric, a composite material, and a method for manufacturing the same, in which the nonwoven fabric includes carbon fibers plated with a metal selected from nickel (Ni), copper (Cu), cobalt (Co), zinc (Zn), gold (Au), silver (Ag), chromium (Cr), tin (Sn), palladium (Pd), rhodium (Rh), iron (Fe), or a combination thereof. A composite material, which is manufactured by blending the nonwoven fabric containing carbon fibers with a resin, exhibits excellent properties in terms of tensile strength and electromagnetic interference (EMI) shielding effectiveness.

EP 4 759 965 A2

**Description**

BACKGROUND OF THE INVENTION

1. Field of the Invention

The present disclosure relates to a nonwoven fabric containing carbon fibers, a composite material, and a method for manufacturing the same. A composite material, which is manufactured by blending the nonwoven fabric containing carbon fibers of the present disclosure with a resin, may exhibit excellent physical properties in terms of tensile strength and electromagnetic interference (EMI) shielding effectiveness.

2. Description of the Related Art

With the advancement of electronic products, electronic components are increasingly being used across a wide range of fields, including mobile phones, smartphones, other electrical appliances, automobiles, and ships. Electronic components emit a large amount of harmful electromagnetic waves, known as electromagnetic interference (EMI), which can create societal problems such as malfunctions of various electronic devices and safety accidents.
In an effort to mitigate EMI effects, researchers are developing novel electromagnetic shielding composite materials by incorporating materials such as carbon, metal, and ceramic into lightweight polymer composites.
As part of the research to manufacture nonwoven fabrics with excellent EMI shielding performance, plating carbon fibers prior to completing the manufacture of nonwoven fabrics has been proposed. While this approach offers relatively high shielding efficiency, it has drawbacks in that it not only increases production costs of fiber yarns but also makes it difficult to control the amount of plating, thereby complicating the manufacture of nonwoven fabrics with the desired weight.
Therefore, there is a need for a technology to manufacture a nonwoven fabric that provides excellent EMI shielding and tensile strength while also being cost-effective.
The foregoing is intended merely to aid in the understanding of the background of the present disclosure, and is not intended to mean that the present disclosure falls within the purview of the related art that is already known to those skilled in the art.

Documents of Related Art

(Patent document 1) Korean Patent No. 10-2326797

SUMMARY OF THE INVENTION

Accordingly, the present disclosure has been made keeping in mind the above problems occurring in the related art, and one objective of the present disclosure is to provide a nonwoven fabric having excellent electromagnetic interference (EMI) shielding effectiveness and tensile strength, a method for manufacturing the same, and a composite material including the nonwoven fabric. The present disclosure further seeks to reduce production costs of the nonwoven fabric, which exhibits excellent EMI shielding effectiveness and tensile strength.
The objectives of the present disclosure are not limited to those mentioned above, and other objectives not mentioned will be clearly understood by those skilled in the art from the description provided hereinafter.
According to one aspect of the present disclosure, there is provided a nonwoven fabric including carbon fibers plated with a metal, wherein the metal may include nickel (Ni), copper (Cu), cobalt (Co), zinc (Zn), gold (Au), silver (Ag), chromium (Cr), tin (Sn), palladium (Pd), rhodium (Rh), iron (Fe), or a combination thereof.
According to another aspect of the present disclosure, there is provided a method for manufacturing a nonwoven fabric, the method including: a first step of adding carbon fibers into a solvent to prepare a carbon fiber dispersion; a second step of drying the carbon fiber dispersion to manufacture a wet-laid nonwoven fabric; and a third step of plating the manufactured wet-laid nonwoven fabric by immersing the wet-laid nonwoven fabric in a plating solution.
According to another aspect of the present disclosure, there is provided a composite material including the nonwoven fabric.
The nonwoven fabric and composite material according to the present disclosure exhibit superior EMI shielding effectiveness and tensile strength, and employ the use of recycled carbon fibers. Therefore, it is possible to manufacture high-quality, cost-effective electromagnetic shielding nonwoven fabrics.

BRIEF DESCRIPTION OF THE DRAWINGS

The above and other objectives, features, and other advantages of the present disclosure will be more clearly understood from the following detailed description when taken in conjunction with the accompanying drawings, in which:

FIG. 1 is a scanning electron microscope (SEM) image of a nonwoven fabric of Preparation Example 1 and;
FIGS. 2A and 2B are scanning electron microscope (SEM) images of plated nonwoven fabrics of Examples 1 and 2, respectively.

DETAILED DESCRIPTION OF THE INVENTION

Hereinafter, the operation and effect of the present disclosure will be described in more detail through specific embodiments and drawings of the disclosure. However, these embodiments are provided only for illustrative purposes and not intended for limiting the scope of the present disclosure.

Prior to describing the embodiments in detail, the terms and words used in the present specification and claims should not be interpreted as being limited to typical meanings or dictionary definitions, but should be interpreted as having meanings and concepts relevant to the technical scope of the present disclosure based on the rule according to which an inventor can appropriately define the concept of the term to describe most appropriately the best method he or she knows for carrying out the present disclosure.

Therefore, embodiments disclosed herein are merely preferred examples of the present disclosure and do not fully describe the technical idea of the present disclosure, so it will be appreciated that there can be various equivalents and alterations thereto at a filing date of the present application.

As used herein, the singular forms are intended to include the plural forms as well, unless the context clearly indicates otherwise. It will be further understood that the terms "comprise", "include", "have", etc., when used in this specification, specify the presence of stated features, integers, steps, operations, elements, components, and/or combinations thereof but do not preclude the presence or addition of one or more other features, integers, steps, operations, elements, components, and/or combinations thereof.

In this specification, when various parameters are given as either a range, a preferred range, or a list of upper preferable values and/or lower preferable values, this is to be understood as specifically disclosing all ranges formed from any pair of any upper range limits or preferred values and any lower range limits or preferred values, regardless of whether the ranges are separately disclosed.

When a range of numerical values is recited herein, unless otherwise stated, the range is intended to include the endpoints thereof, and all integers and fractions within the range.

The scope of the present disclosure is intended not to be limited to specific values used in defining a range for a certain parameter.

In this specification, "a to b" and "a~b" indicating a numerical range are defined as $\geq$ a and $\leq$ b.

Hereinafter, exemplary embodiments will be described in detail, but the present disclosure is not limited thereto.

A nonwoven fabric according to one aspect of the present disclosure may include carbon fibers plated with a metal, wherein the metal may include nickel (Ni), copper (Cu), cobalt (Co), zinc (Zn), gold (Au), silver (Ag), chromium (Cr), tin (Sn), palladium (Pd), rhodium (Rh), iron (Fe), or a combination thereof.

In one embodiment of the present disclosure, the plating may be performed by an electroless plating method, an electroplating method, or a combination thereof.

For example, the carbon fibers may be plated one or more times by electroplating, or plated one or more times by electroless plating. Alternatively, the nonwoven fabric may be plated one or more times by electroless plating followed by one or more times by electroplating.

Additionally, the combination of primarily performing electroless plating followed by electroplating may be defined as one cycle, and the carbon fibers may be plated by repeating this cycle.

At this time, the plating may be performed after the manufacture of the nonwoven fabric. That is, a nonwoven fabric manufactured using carbon fibers may be plated to form a plating layer on the carbon fibers.

In one embodiment of the present disclosure, the carbon fibers may be plated with copper by an electroless plating method, and, following the copper plating, may be additionally plated with nickel by an electroplating method.

In one embodiment of the present disclosure, the weight increase rate of the nonwoven fabric after plating may be equal to or greater than 10%.

At this time, the method for measuring the weight increase rate of the nonwoven fabric after plating may be based on Equation 1 below.

Weight increase rate of nonwoven fabric [%] = [(weight of nonwoven fabric after plating - weight of nonwoven fabric before plating)/weight of nonwoven fabric before plating] $\times$ 100    <Equation 1>

For example, the weight increase rate of the nonwoven fabric after plating may be 10% to 70%, 20% to 65%, 30% to 60%, or 40% to 55%.

When the weight increase rate of the nonwoven fabric after plating falls below 5%, the electromagnetic shielding effect and the tensile strength of the nonwoven fabric may be insufficient.

In one embodiment of the present disclosure, the basis weight of the nonwoven fabric before plating may be 10 to 200 $g/m^2$, and the basis weight of the nonwoven fabric after plating may be 11 to 1,000 $g/m^2$.

For example, the basis weight of the nonwoven fabric before plating may be 15 to 190 $g/m^2$, 10 to 180 $g/m^2$, 25 to 170 $g/m^2$, 30 to 160 $g/m^2$, 35 to 150 $g/m^2$, 40 to 140 $g/m^2$, 45 to 130 $g/m^2$, 50 to 120 $g/m^2$, 55 to 110 $g/m^2$, 60 to 100 $g/m^2$, or 70 to 90 $g/m^2$.

For example, the basis weight of the nonwoven fabric after plating may be 11 to 1,000 $g/m^2$, 20 to 900 $g/m^2$, 30 to 800 $g/m^2$, 40 to 700 $g/m^2$, 50 to 600 $g/m^2$, 60 to 500 $g/m^2$, 70 to 400 $g/m^2$, 80 to 300 $g/m^2$, 90 to 200 $g/m^2$, or 100 to 150 $g/m^2$.

For example, when a nonwoven fabric with a basis weight of 80 $g/m^2$ before plating, made from carbon fibers, is plated, the basis weight after plating may be 110 to 130 $g/m^2$.

In one embodiment of the present disclosure, the carbon fibers may include pitch-based, polyacrylonitrile (PAN)-based, rayon-based fibers, or a combination thereof.

In one embodiment of the present disclosure, the carbon fibers may include recycled carbon fibers. However, the carbon fibers is not limited to recycled carbon fibers, and may include virgin carbon fibers, recycled carbon fibers, or a combination thereof.

In one embodiment of the present disclosure, the carbon fibers may have an average length of equal to or greater than 20 mm.

For example, the average length of the carbon fibers may be 20 to 200 mm, 25 to 170 mm, 30 to 140 mm, 35 to 110 mm, 40 to 80 mm, or 45 to 60 mm.

At this time, when the average length of the carbon fibers exceeds the range defined herein, dispersibility may be low, resulting in the manufactured nonwoven fabric not having uniform tensile strength and electrical conductivity. Whereas, when the average length of the carbon fibers falls below the range defined herein, it may be difficult to secure sufficient wet strength, resulting in disintegration of the carbon fibers in the nonwoven fabric during the plating process.

In the case of a nonwoven fabric manufactured using carbon fibers having the average length range defined herein, it can provide excellent wet strength due to a strong bond between the carbon fibers. As a result, it is possible to either eliminate the use of a binder or reduce the binder content, allowing the nonwoven fabric to be manufactured at relatively low cost.

In one embodiment of the present disclosure, the nonwoven fabric may have an electromagnetic interference (EMI) shielding effectiveness of equal to or greater than 30 dB, as measured in accordance with ASTM-D4935.

For example, the EMI shielding effectiveness measured in accordance with ASTM-D4935 may be 40 to 100 dB, 45 to 99 dB, 50 to 98 dB, 55 to 97 dB, 60 to 96 dB, or 65 to 95 dB.

When electromagnetic waves are shielded using the nonwoven fabric of the present disclosure, the intensity of the electromagnetic waves after shielding may be at a level of 1/1,500,000 to 1/500,000 relative to the intensity of the electromagnetic waves before shielding.

For example, the intensity of the electromagnetic waves after shielding may be 1/1,400,000 to 1/600,000, 1/1,300,000 to 1/700,000, 1/1,200,000 to 1/800,000, or 1/1,100,000 to 1/900,000, relative to the intensity of the electromagnetic waves before shielding.

At this time, the EMI shielding effectiveness of the nonwoven fabric may refer to the average value of the EMI shielding effectiveness measured at 30 MHz to 1.5 GHz in accordance with ASTM-D4935.

That is, the nonwoven fabric of the present disclosure can exhibit excellent EMI shielding performance in the high-frequency range.

In one embodiment of the present disclosure, the nonwoven fabric may have a tensile strength of equal to or greater than 5 MPa, as measured in accordance with KS K ISO 9073-3.

For example, the tensile strength of the nonwoven fabric measured in accordance with KS K ISO 9073-3 may be 20 to 200 MPa, 50 to 195 MPa, 80 to 190 MPa, 110 to 185 MPa, or 140 to 180 MPa.

A nonwoven fabric having a tensile strength below the range defined herein may fail to secure sufficient wet strength, making plating impossible.

A method for manufacturing a nonwoven fabric according to another aspect of the present disclosure may include: a first step of adding the carbon fibers into a solvent to prepare a carbon fiber dispersion; a second step of drying the carbon fiber dispersion to prepare a wet-laid nonwoven fabric; and a third step of plating the prepared wet-laid nonwoven fabric by immersing the wet-laid nonwoven fabric in a plating solution.

In one embodiment of the present disclosure, the first step may include additionally adding binder fibers, binder polymers, or a combination thereof.

The binder fibers or binder polymers are used to increase the bonding strength of the nonwoven fabric after the drying step during its manufacture, and may include, for example, polyvinyl alcohol (PVA) fibers, low-melting-point polyester (LMPET) fibers, polyvinyl alcohol resins, etc.

The binder fibers may be included in an amount of 0.001 to 5 wt% based on a total of 100 wt% of the carbon fiber dispersion.

When the amount of the binder fibers falls below the range defined herein, suitable strength may not be achieved.

In one embodiment of the present disclosure, the first step may include adding a wetting agent. The wetting agent may include a cationic surfactant, an anionic surfactant, a nonionic surfactant, or a combination thereof.

For example, the wetting agent may include an ethylene oxide (EO)/propylene oxide (PO) copolymer surfactant, a polyethylene oxide (PEO)-based surfactant, a polyethylene glycol (PEG)-based surfactant, or a combination thereof.

In one embodiment of the present disclosure, the plating solution may include nickel (Ni), copper (Cu), cobalt (Co), zinc (Zn), gold (Au), silver (Ag), chromium (Cr), tin (Sn), palladium (Pd), rhodium (Rh), iron (Fe), or a combination thereof.

In one embodiment of the present disclosure, the plating method in the third step may be an electroless plating method, an electroplating method, or a combination thereof.

For example, the nonwoven fabric may be plated one or more times by electroplating, or plated one or more times by electroless plating. Alternatively, the nonwoven fabric may be plated one or more times by electroless plating followed by one or more times by electroplating.

Additionally, the combination of primarily performing electroless plating followed by electroplating may be defined as one cycle, and the nonwoven fabric may be plated by repeating this cycle.

In one embodiment of the present disclosure, the plating solution for the electroless plating method may have an acidity (pH) of 3 to 15.

The pH of the plating solution for the electroless plating method may vary depending on the type of metal.

For example, in electroless plating using nickel, the optimal pH may be 4.0 to 7.0; for copper, 11.0 to 13.0; for silver, 8.0 to 10.0; and for gold, 6.0 to 8.0.

The optimal pH may serve as one of the key factors for maintaining the desired reaction between metal ions and reducing agents. In other words, when plating occurs within the optimal pH range defined herein, it can help maintain the chemical reaction balance within the plating solution.

When the pH of the plating solution exceeds or falls below the optimal pH range for each metal, a plating bath may become unstable, sediment may form in the bath, and the components of the plating solution may deteriorate.

Additionally, the pH exceeding or below the optimal pH range for each metal may lead to excessively fast or slow plating rate, resulting in the formation of a non-uniform plating layer.

Moreover, the pH exceeding the optimal pH range for each metal may cause excessive plating reactions, potentially incorporating impurities into the formed plating layer. Whereas, the pH below the optimal pH range for each metal may hinder precipitation of metal ions, resulting in the formation of an insufficient plating layer.

The pH of the plating solution for the electroless plating method may be adjusted using sulfuric acid ($H_2SO_4$), hydrochloric acid (HCl), acetic acid ($CH_3COOH$), nitric acid ($FNO_3$), phosphoric acid ($H_3PO_4$), hydrogen sulfide ($H_2S$), sodium hydroxide (NaOH), ammonia ($NH_3$), potassium hydroxide (KOH), sodium carbonate ($Na_2CO_3$), ammonium hydroxide ($NH_4OH$), potassium carbonate ($K_2CO_3$), or a combination thereof, without being limited thereto.

In one embodiment of the present disclosure, the temperature of the plating solution for the electroless plating method may be 10°C to 100°C.

The temperature of the plating solution for the electroless plating method may vary depending on the type of metal.

For example, in electroless plating using nickel, the optimal temperature of the plating solution may be 85°C to 95°C; for copper, 20°C to 40°C; for silver, 30°C to 50°C; and for gold, 50°C to 70°C.

When the temperature of the plating solution for the electroless plating method exceeds the optimal temperature range for each metal, the plating rate may become excessively fast, resulting in a non-uniform plating layer or defects in the formed plating layer. Whereas, when the temperature of the plating solution falls below the optimal temperature range for each metal, the plating rate may become too slow, and the plating reaction may not proceed sufficiently, resulting in a plating layer with a density less than the desired plating density.

In one embodiment of the present disclosure, the plating time for the electroless plating method may be 10 minutes to 1 hour.

For example, the plating time for the electroless plating method may be 15 to 55 minutes, 20 to 50 minutes, 23 to 45 minutes, 25 to 40 minutes, or 27 to 35 minutes.

The plating time for the electroless plating method may be set differently depending on the desired thickness of the plating layer.

At this time, the longer the plating time for the electroless plating method, the thicker the formed plating layer may become. Even with the same desired thickness of the plating layer, the time required to achieve the desired thickness may vary depending on the metal ion concentration of the plating solution, the temperature of the plating solution, and the pH of the plating solution.

When the plating time for the electroless plating method exceeds the range defined herein, the surface of the formed plating layer may become rough or uneven, thereby reducing its quality. Whereas, when the plating time falls below the range defined herein, a sufficiently thick plating layer may not form.

At this time, the plating time for the electroless plating method may be set differently depending on the desired thickness of the plating layer, the concentration of the plating solution, the temperature of the plating solution, the pH of the plating solution, or a combination thereof.

For example, a lower concentration of the plating solution may lead to a longer plating time, and an unoptimized temperature or pH of the plating solution for plating may slow down the plating process, causing a plating layer to form slowly or not properly.

In one embodiment of the present disclosure, the plating solution for the electroplating method may have an acidity (pH) of 0.5 to 15.

The pH of the plating solution for the electroplating method may vary depending on the type of metal.

For example, in electroplating using nickel, the optimal pH may be 4.0 to 5.5; for copper, 0.5 to 3.0 or 8.5 to 12.0; for silver, 9.0 to 10.5; for gold, 4.0 to 6.0; for zinc, 4.5 to 5.5 or 12.0 to 14.0; and for chromium, 1.0 to 2.5.

When the pH of the plating solution for the electroplating method exceeds or falls below the optimal pH range for each metal, the plating rate may become excessively fast or slow, resulting in the formation of a non-uniform plating layer, accompanied by poor plating quality.

The pH of the plating solution for the electroplating method may be adjusted using sulfuric acid ($H_2SO_4$), hydrochloric acid (HCl), acetic acid ($CH_3COOH$), nitric acid ($HNO_3$), phosphoric acid ($H_3PO_4$), hydrogen sulfide ($H_2S$), sodium hydroxide (NaOH), ammonia ($NH_3$), potassium hydroxide (KOH), sodium carbonate ($Na_2CO_3$), ammonium hydroxide ($NH_4OH$), potassium carbonate ($K_2CO_3$), or a combination thereof, without being limited thereto.

In one embodiment of the present disclosure, the temperature of the plating solution for the electroplating method may be 10°C to 80°C.

The temperature of the plating solution for the electroplating method may vary depending on the type of metal.

For example, in electroplating using nickel, the optimal temperature of the plating solution may be 50°C to 60°C; for copper, 20°C to 60°C; for silver, 20°C to 30°C; for gold, 50°C to 70°C; for zinc, 20°C to 40°C; and for chromium, 45°C to 60°C.

At this time, the optimal temperature range of the plating solution for electroplating may vary depending on the acidity of the plating solution.

For example, in electroplating using copper, the optimal temperature of the plating solution may be 20°C to 30°C when the plating solution is acidic, and 50°C to 60°C when the plating solution is alkaline.

For example, in electroplating using zinc, the optimal temperature of the plating solution may be 20°C to 30°C when the plating solution is acidic, and 20°C to 40°C when the plating solution is alkaline.

Increasing the temperature of the plating solution for the electroplating method accelerates the plating rate, but exceeding the range defined herein may cause defects in the formed plating layer or contribute to the instability of the plating solution itself.

When the temperature of the plating solution for the electroplating method falls below the range defined herein, the formed plating layer may become non-uniform and the plating rate may become slow.

In one embodiment of the present disclosure, the plating time for the electroplating method may be 5 to 120 minutes.

At this time, the plating time for the electroplating method may vary depending on the type of metal.

For example, the plating time for the electroplating method may be 6 to 25 minutes, 7 to 20 minutes, 8 to 15 minutes, or 9 to 12 minutes.

The plating time for the electroplating method may vary depending on the type of metal.

When the plating time for the electroplating method exceeds or falls below the range defined herein, the plating layer may be insufficient or non-uniformly formed.

Additionally, the plating solution may further include a solvent, an electrolyte, a brightener, a complexing agent, a reducing agent, a catalyst, or a combination thereof, which are commonly used in electroless or electroplating processes.

For example, the plating solution for the electroless plating method may include sulfuric acid ($H_2SO_4$), hydrogen peroxide ($H_2O_2$), hydrochloric acid (HCl), hydrofluoric acid (HF), or a combination thereof for etching, palladium dichloride ($PdCl_2$) as a catalyst, and hydrochloric acid (HCl), nitric acid ($HNO_3$), or a combination thereof as an activator.

Additionally, the plating solution for the electroless plating method may include tetrasodium EDTA ($Na_4$ EDTA), citric acid ($C_6H_8O_7$), citric acid ($C_6H_8O_7$), glycine, or a combination thereof as a complexing agent, and formaldehyde (HCHO), glucose, sodium hypophosphite, hydrazine, sodium sulfite, boron compounds, or a combination thereof as a reducing agent.

For example, the plating solution for the electroplating method may include boric acid ($H_3BO_3$), saccharin, or a combination thereof.

In one embodiment of the present disclosure, the third step may include performing electroless plating.

In one embodiment of the present disclosure, the third step may include performing electroless plating followed by electroplating.

For example, electroless plating with copper may be repeated one or more times, electroless plating with copper may be repeated one or more times followed by one or more times by electroplating with nickel, or the combination of primarily performing electroless plating with copper followed by electroplating with nickel may be defined as one cycle, which may be repeated one or more times.

A composite material according to another aspect of the present disclosure may include the nonwoven fabric.

The composite material may include a resin. The resin may include an epoxy resin, a phenol resin, a polyester resin, a silicone resin, a polyethylene resin, a polypropylene resin, a polystyrene resin, a polycarbonate resin, a polyamide resin, a polyurethane resin, or a combination thereof.

The composite material may be manufactured by preparing a prepreg in which the nonwoven fabric is blended with the resin using a hot melt method, a solution impregnation method, or a combination thereof, and then stacking one or more layers of the prepreg.

Additionally, after the stacking of the prepreg, molding, cooling, and demolding may be further performed.

Hereinafter, the operation and effect of the present disclosure will be described in more detail through specific examples of the disclosure. However, these examples are provided only for illustrative purposes and not intended for limiting the scope of the present disclosure.

**Preparation Example 1**

A wet-laid nonwoven fabric with a basis weight of 80 $g/m^2$ was manufactured using 50 mm carbon fibers as follows.

Hereinafter, wt % is based on a total weight of 2,500g.

0.15 wt% of 50 mm carbon fibers (from Zolteck) and 0.15 wt% of a nonionic surfactant-based wetting agent were added to a solvent (water, 492.5 g) and mixed. The resultant was then subjected to pre-wetting using a pulper at about 1,000 rpm to prepare a pre-wetting solution.

Subsequently, 0.6 wt% of an acrylic dispersant (CDS-3000P, from Hansol) was dissolved in a solvent (water, about 1977.5 g), after which 500 g of the pre-wetting solution was added. The mixed solution was stirred at a low speed of about 250 to 350 rpm using an impeller designed to minimize vortex formation, thereby preparing a carbon fiber dispersion.

The prepared carbon fiber dispersion was formed into a sheet using a $25 \times 25$ $cm^2$ sheet machine. The formed sheet was then dried in a hot-air drying oven at 120°C for about 30 minutes, thereby manufacturing a carbon fiber wet-laid nonwoven fabric with a basis weight after drying of 80 $g/m^2$.

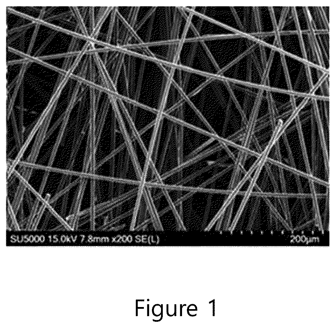

The manufactured carbon fiber wet-laid nonwoven fabric was observed using a scanning electron microscope (SEM) and the results are shown in FIG. 1.

**Preparation Example 2**

The same procedure was carried out as in Preparation Example 1, except that 6 mm carbon fibers were used.

**Preparation Example 3**

The same procedure was carried out as in Preparation Example 1, except that 12 mm carbon fibers were used.

**Example 1**

A wet-laid nonwoven fabric manufactured in Preparation Example 1 was subjected to electroplating with nickel as follows.

The nickel electroplating was performed for 10 minutes under conditions: a temperature of 55°C, a pH of 4.0, and a current density of 3.5 $A/dm^2$. The composition of a plating bath is summarized in Table 1 below.

Table 1

| Component | Content (g/L) |
| --- | --- |
| Nickel sulfate ($NiSO_4 \cdot 6H_2O$) | 240 |
| Nickel chloride ($NiCl_2 \cdot 6H_2O$) | 45 |
| Boric acid ($H_3BO_3$) | 30 |

(continued)

| Component | Content (g/L) |
|---|---|
| Saccharin | 1 |
| Sodium acetate | 5 |

After the nickel electroplating, the resultant was washed with distilled water and then dried at 100°C for 10 minutes.

**Example 2**

A wet-laid nonwoven fabric manufactured in Preparation Example 1 was primarily subjected to electroless plating with copper followed by electroplating with nickel as follows.

The wet-laid nonwoven fabric manufactured in Preparation Example 1 was washed with distilled water at room temperature for 1 minute, then treated with 30 g/L of NaOH at 50°C for 5 minutes, followed by another 1-minute washing with distilled water at room temperature. Subsequently, a plating pretreatment was performed at room temperature in the following sequence: etching - washing - catalysis - washing - activation - washing. The compositions of solutions used in the pretreatment step are summarized in Table 2 below.

Table 2

| Step | Component | Content |
|---|---|---|
| Etching | Sulfuric acid ($H_2SO_4$) | 120 g/L |
| Catalysis | Palladium dichloride ($PdCl_2$) | 0.25 g/L |
| | Tin dichloride ($SnCl_2$) | 15 g/L |
| Activation | Hydrochloric acid (HCl) | 15% |
| Washing | Distilled water | - |

In this procedure, the duration of each step was as follows: 5 minutes for the etching step, 3 minutes for the catalysis step, 1 minute for the activation step, and 1 minute for the washing step.

The pretreated nonwoven fabric was subjected to electroless plating with copper under conditions: a temperature of 30°C, a pH of 12, and a duration of 30 minutes. The composition of a plating bath is summarized in Table 3 below. At this time, sodium hydroxide was added to adjust the pH of the plating bath to 12.

Table 3

| Component | Content |
|---|---|
| Copper sulfate ($CuSO_4 \cdot 5H_2O$) | 15g/L |
| Tetrasodium EDTA ($Na_4EDTA$) | 55 g/L |
| Formaldehyde (HCHO) | 3 ml/L |
| Sodium hydroxide (NaOH) | pH 12 |

After performing electroless plating with copper, additional electroplating with nickel was followed. The nickel electroplating was carried out in the same manner as in Example 1.

**Comparative Example 1**

A wet-laid nonwoven fabric manufactured in Preparation Example 2 was subjected to electroplating with nickel in the same manner as in Example 1.

**Comparative Example 2**

A wet-laid nonwoven fabric manufactured in Preparation Example 2 was primarily subjected to electroless plating

8

with copper followed by electroplating with nickel in the same manner as in Example 2.

### Comparative Example 3

A wet-laid nonwoven fabric manufactured in Preparation Example 3 was subjected to electroplating with nickel in the same manner as in Example 1.

### Comparative Example 4

A wet-laid nonwoven fabric manufactured in Preparation Example 3 was primarily subjected to electroless plating with copper followed by electroplating with nickel in the same manner as in Example 2.

### Evaluation Example 1

For each of the Examples and Comparative Examples, the presence or absence of a plating layer was confirmed. The weight and basis weight of the nonwoven fabric before and after plating were measured to determine the weight increase rate.

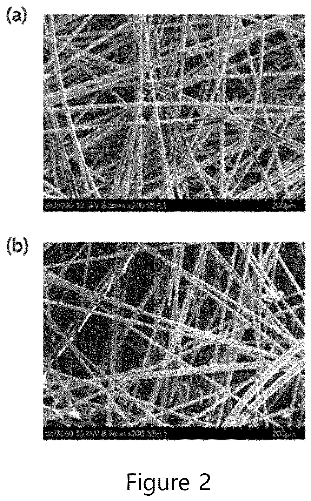

The surfaces of Examples 1 and 2 were observed using a scanning electron microscope (SEM) and the results are shown in FIG. 2A and FIG. 2B, respectively. From each figure, it can be seen that a plating layer was successfully formed on the carbon fibers.

Meanwhile, in Comparative Examples 1 to 4, the fibers were not long enough for the plating process and disintegrated upon application, making plating impossible.

Preparation Example 1 was manufactured with a weight of 5 g and a size of 25*25 cm$^2$ based on a basis weight of 80 g/m$^2$. After plating, the weights of Examples 1 and 2 were 7.47 g and 7.65 g, respectively.

As a result of calculating the basis weights (weights per unit area (1 m* 1 m)) of Example 1 and Example 2 after plating, they were found to be 119.5 g/m$^2$ and 122.4 g/m$^2$, respectively.

The weight increase rates of the nonwoven fabrics of Examples 1 and 2 were calculated by percentage based on Equation 1 below, and the results are summarized in Table 4.

Weight increase rate of nonwoven fabric [%] = [(weight of nonwoven fabric after plating - weight of nonwoven fabric before plating)/weight of nonwoven fabric before plating] $\times$ 100 <Equation 1>

Table 4

|  | Example 1 | Example 2 |
|---|---|---|
| Weight before plating | 5g | 5g |
| Weight after plating | 7.47 g | 7.65 g |
| Basis weight after plating | 119.5 g/m$^2$ | 122.4 g/m$^2$ |
| Weight increase rate of nonwoven fabric | 49% | 53% |

### Evaluation Example 2

For the Preparation Examples and Examples, the electromagnetic interference (EMI) shielding effectiveness was evaluated in accordance with ASTM-D4935 at 200 frequency points within the range of 30 MHz to 1.5 GHz. The average values are summarized in Table 5 below.

In the Comparative Examples, the nonwoven fabrics disintegrated, making it impossible to measure their EMI shielding effectiveness.

Table 5

|  | Preparation Example 1 | Preparation Example 2 | Preparation Example 3 | Example 1 | Example 2 |
|---|---|---|---|---|---|
| EMI shielding effectiveness (dB) | 60.11 | 33.67 | 58.54 | 71.48 | 91.69 |

Compared to Preparation Examples 1 to 3, Examples 1 and 2, which were undergone plating, exhibited superior EMI shielding effectiveness. In particular, Example 2, which were electroless plated with copper followed by electroplating with nickel, demonstrated the highest EMI shielding effectiveness.

**Evaluation Example 3**

For the Preparation Examples and Examples, the tensile strength was evaluated in accordance with KS K ISO 9073-3, and the results are summarized in Table 6 below.
In the Comparative Examples, the nonwoven fabrics disintegrated, making it impossible to measure their tensile strength.

Table 6

|  | Preparation Example 1 | Preparation Example 2 | Preparation Example 3 | Example 1 | Example 2 |
|---|---|---|---|---|---|
| Tensile strength (MPa) | 149.0 | 9.5 | 37.4 | 169.4 | 177.0 |

Compared to Preparation Examples 1 to 3, Examples 1 and 2, which were undergone plating, exhibited superior tensile strength. In particular, Example 2, which were electroless plated with copper followed by electroplating with nickel, demonstrated the highest tensile strength.
Although preferred embodiments of the present disclosure have been disclosed in detail, those skilled in the art will appreciate that various alternatives, modifications, and equivalents are possible, without changing the spirit or essential features of the present disclosure. Therefore, preferred embodiments of the present disclosure have been described for illustrative purposes, and should not be construed as being restrictive.
The scope of the present disclosure is defined by the appended claims rather than the above detailed description, and all changes or modifications derived from the meaning and range of the appended claims and equivalents thereof are to be interpreted as being included within the scope of present disclosure.

**Claims**

1. A nonwoven fabric comprising carbon fibers plated with a metal,
   wherein the metal includes nickel (Ni), copper (Cu), cobalt (Co), zinc (Zn), gold (Au), silver (Ag), chromium (Cr), tin (Sn), palladium (Pd), rhodium (Rh), iron (Fe), or a combination thereof.

2. The nonwoven fabric of claim 1, wherein the plating is performed by an electroless plating method, an electroplating method, or a combination thereof.

3. The nonwoven fabric of claim 1, wherein the nonwoven fabric has a weight increase rate of equal to or greater than 10% after plating, as determined by Equation 1 below.

   Weight increase rate of nonwoven fabric [%] = [(weight of nonwoven fabric after plating - weight of nonwoven fabric before plating)/weight of nonwoven fabric before plating] × 100          <Equation 1>

4. The nonwoven fabric of claim 1, wherein the carbon fibers include pitch-based, polyacrylonitrile (PAN)-based, rayon-based fibers, or a combination thereof.

5. The nonwoven fabric of claim 1, wherein the carbon fibers include recycled carbon fibers.

6. The nonwoven fabric of claim 1, wherein the carbon fibers have an average length of equal to or greater than 20 mm.

7. The nonwoven fabric of claim 1, wherein the nonwoven fabric has an electromagnetic interference (EMI) shielding effectiveness of equal to or greater than 30 dB, as measured in accordance with ASTM-D4935.

8. The nonwoven fabric of claim 1, wherein the nonwoven fabric has a tensile strength of equal to or greater than 5 MPa, as measured in accordance with KS K ISO 9073-3.

9. A method for manufacturing a nonwoven fabric, the method comprising:

   a first step of adding carbon fibers into a solvent to prepare a carbon fiber dispersion;
   a second step of drying the carbon fiber dispersion to manufacture a wet-laid nonwoven fabric; and
   a third step of plating the manufactured wet-laid nonwoven fabric by immersing the wet-laid nonwoven fabric in a plating solution.

10. The method of claim 9, wherein the carbon fibers have an average length of equal to or greater than 20 mm.

11. The method of claim 9, wherein the plating solution includes nickel (Ni), copper (Cu), cobalt (Co), zinc (Zn), gold (Au), silver (Ag), chromium (Cr), tin (Sn), palladium (Pd), rhodium (Rh), iron (Fe), or a combination thereof.

12. The method of claim 9, wherein the plating in the third step includes an electroless plating method, an electroplating method, or a combination thereof.

13. The method of claim 9, wherein the third step includes performing electroless plating with copper.

14. The method of claim 9, wherein the third step includes performing electroless plating with copper followed by electroplating with nickel.

15. A composite material comprising the nonwoven fabric of any one of claims 1 to 8.

Figure 1

(a)

(b)

Figure 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 102326797